# EUROPEAN PATENT APPLICATION

(11) **EP 4 778 970 A1**
(43) Date of publication of application: **22.07.2026**
(21) Application number: 24865748.8
(22) Date of filing: 03.09.2024
(51) Int. Cl.: C08K 5/5435, C08L 63/00, H01L 23/29

(54) **EPOXY RESIN COMPOSITION FOR MOLDING**

(30) Priority: 11.09.2023 KR 20230120636
(71) Applicant: Momentive Performance Materials Inc., Niskayuna, NY 12309 (US)
(72) Inventor: LEE, Jung Han, Yongin-si, Gyeonggi-do 16917 (KR); SHIM, Myoung Taek, Gwangju 62246 (KR); KONG, Byung Seon, Yongin-si, Gyeonggi-do 17013 (KR); IJIMA, Yoichiro, Fujisawa City, Kanagawa 251-0021 (JP); MOCHIZUKI, Kyohei, Yokohama City, Kanagawa 222-0011 (JP); SASAKI, Motoshi, Ohta City, Gunma 370-0841 (JP); SIVASUBRAMANIAN, Karthikeyan, Bangalore 560102 (IN); KAUR, Banpreet, 14197 Berlin (DE); PHUKAN, Monjit, New York 10604 (US)
(74) Representative: Pfenning, Meinig & Partner mbB
(86) International application number: PCT/KR2024/013212
(87) International publication number: WO 2025/058307

(57) **Abstract**

The present invention relates to an epoxy resin composition for molding and a semiconductor device molded by using the same.

## Description

### [Technical Field]

The present invention relates to an epoxy resin composition for molding and a semiconductor device molded by using the same.

### [Background Art]

A resin composition for encapsulation is used as a material that improves the properties and reliability of semiconductor devices by sealing semiconductor elements such as integrated circuits (ICs), large-capacity integrated circuits (LSIs), transistors, and diodes. Recently, as high integration of semiconductors is accelerated in accordance with trends in miniaturization, weight reduction, and high performance of electronic devices, research to improve the performance of materials used for sealing semiconductor devices is continuing in various fields. For example, Japanese Patent Publication No. 2017-197620 relates to an epoxy resin composition for semiconductor encapsulation, comprising an epoxy resin, a phenol resin curing agent and a filler, and discloses a technique for increasing electrical connection reliability by adjusting the content of a filler and the thermal elasticity of a cured product of an epoxy resin composition.

In particular, in order to provide an epoxy resin composition having a high heat dissipation property, a high content of a filler should be included to increase thermal conductivity. In this case, there is a problem of poor dispersibility. Accordingly, it is necessary to develop an epoxy resin composition for molding having excellent dispersibility, flowability and thermal conductivity.

### [Detailed Description of Invention]

### [Technical Problem]

The present invention provides an epoxy resin composition for molding having excellent dispersibility, flowability and thermal conductivity, and a semiconductor device molded by using the same.

### [Technical Solution]

The present invention provides an epoxy resin composition comprising an epoxy resin, a curing agent, a filler, and a siloxane, wherein the siloxane is a disiloxane of a symmetrical structure having an alicyclic epoxy group at both ends.

### [Advantageous Effects]

The present invention provides an epoxy resin composition for molding having excellent dispersibility, flowability and thermal conductivity. In addition, the epoxy resin composition according to the present invention has excellent properties including strength, glass transition temperature, etc. The epoxy resin composition according to the present invention has excellent thermal conductivity, and thus can be applied as a molding compound having a high heat dissipation property.

### [Best Mode]

Hereinafter, the present invention will be described in detail. However, the present invention is not limited only by the following contents, and each component may be variously modified or optionally mixed as needed. Therefore, it should be understood to include all modifications, equivalents, and substitutes included in the spirit and scope of the present invention.

The "softening point" used herein is measured by a conventional method known in the art, and can be measured, for example, with a dropping point system calorimetry DP70 from Mettler Toledo. The "viscosity" is measured by a conventional method known in the art, and can be measured by using, for example, a Brookfield viscometer, at room temperature (25 °C). The "particle size (D50)" is measured by a conventional method known in the art, and can be measured, for example, by a laser particle size analyzer.

### <Epoxy Resin Composition>

The epoxy resin composition according to the present invention includes an epoxy resin, a curing agent, a filler, and a siloxane. The present invention provides an epoxy resin composition for encapsulating a semiconductor device, which has excellent dispersibility, flowability and thermal conductivity, by using a disiloxane of a symmetrical structure having an alicyclic epoxy group at both ends.

The epoxy resin composition of the present invention can be manufactured in liquid form, powder form, granule form, or sheet form, and can be used as a sealing material (epoxy molding compound (EMC)) for semiconductor devices or a molding material or fixing material for various electronic parts and automotive parts. In one example, the epoxy resin composition for molding, of the present invention, can be applied for sealing of large-area semiconductor packages that are large in size and thin in thickness, and may be made of granular EMC that can be applied to a compression-type molding process, a C-molding process, or a lamination process.

### Epoxy Resin

The epoxy resin composition of the present invention includes an epoxy resin. The epoxy resin is used as a main resin and reacts with a curing agent to form a three-dimensional network structure after curing, thereby imparting strong and firm adhesive properties and heat resistance to an object to be adhered.

As the epoxy resin, epoxy resin commonly used in the art may be used. Non-limiting examples of a usable epoxy resin include a bisphenol A type epoxy resin, alicyclic type epoxy resin, cresol novolac type epoxy resin, bisphenol F type epoxy resin, bisphenol S type epoxy resin, naphthalene type epoxy resin, anthracene type epoxy resin, tetramethyl biphenyl type epoxy resin, phenol novolac type epoxy resin, bisphenol A novolac type epoxy resin, bisphenol S novolac type epoxy resin, biphenyl novolac type epoxy resin, naphthol novolac type epoxy resin, naphthol phenol coaxial novolac type epoxy resin, naphthol cresol coaxial novolac type epoxy resin, aromatic hydrocarbon form aldehyde resin modified phenol resin type epoxy resin, triphenyl methane type epoxy resin, tetraphenyl ethane type epoxy resin, dicyclopentadiene type epoxy resin, dicyclopentadiene phenol addition reaction type epoxy resin, biphenyl type epoxy resin, phenol aralkyl type epoxy resin, polyfunctional phenolic resin, naphthol aralkyl type epoxy resin, etc., and may include at least one of these epoxy resins.

In one example, the epoxy resin may include 4,4-bis(2,3-epoxypropoxy)-3,3,5,5-tetramethyl(1,1-biphenyl). In this case, the effect of lowering the viscosity of the epoxy resin composition and increasing the flowability can be exhibited more effectively.

As the epoxy resin, one having an epoxy equivalent weight (EEW) of 100-500 g/eq, for example, 150-300 g/eq, may be used. When the EEW is less than the range stated above, the curability, flowability and formability may be deteriorated, and when the EEW exceeds the range stated above, the strength and adhesion may be deteriorated.

As the epoxy resin, one having a softening point of 30-150 °C, for example, 50-110 °C, may be used. When the softening point is less than the range stated above, the curability, flowability and formability may be deteriorated, and when the softening point exceeds the range stated above, reactivity may be delayed, and thus, dispersibility may be lowered.

On the basis of the total weight of the epoxy resin composition, the content of the epoxy resin may be 1-20% by weight, for example, 1.5-10% by weight. When the content of the epoxy resin is less than the range stated above, adhesiveness, flowability, and formability may be deteriorated, and when the content of the epoxy resin exceeds the range stated above, the reliability of the semiconductor may be deteriorated due to an increase in moisture absorption, and the strength may be lowered due to a relative decrease in the content of fillers.

### Curing Agent

The epoxy resin composition of the present invention includes a curing agent. The curing agent reacts with the epoxy resin to promote curing of the composition.

As the curing agent, a curing agent known in the art to undergo a curing reaction with epoxy resin may be used, and the curing agent may be a phenolic compound having two or more phenolic hydroxyl groups in one molecule. Non-limiting examples of a usable curing agent may include phenol novolac resin, cresol novolac resin, phenol aralkyl resin, polyfunctional phenol compound, etc., and may include one or more of these curing agents.

In one example, the curing agent may include phenol polymer with 4,4-bis(methoxymethyl)1,1-bisphenyl, phenol polymer with 1,4-bis(methoxymethyl)benzene, or mixtures thereof. In one example, the curing agent may include phenol polymer with bis(methoxymethyl)1,1-bisphenyl and phenol polymer with 1,4- bis(methoxymethyl)benzene. In this case, further improved dispersibility and reliability can be secured.

As the curing agent, one having a hydroxy equivalent weight of 90-300 g/eq, for example, 100-200 g/eq, may be used. When the hydroxy equivalent weight is less than the range stated above, the curability, flowability and formability may be deteriorated, and when the hydroxy equivalent weight exceeds the range stated above, the adhesion may be deteriorated.

As the curing agent, one having a softening point of 50-120 °C, for example, 55-90 °C, may be used. When the softening point is less than the range stated above, the curability, flowability and formability may be deteriorated, and when the softening point exceeds the range stated above, the curing reaction may be retarded, and thus, dispersibility may be lowered.

On the basis of the total weight of the epoxy resin composition, the content of the curing agent may be 1-20% by weight, for example, 1-10% by weight. When the content of the curing agent is less than the range stated above, the curability and formability may be lowered, and when the content of the curing agent exceeds the range stated above, the reliability of the semiconductor may be deteriorated and the strength may be lowered, due to an increase in moisture absorption.

### Filler

The epoxy resin composition of the present invention includes a filler. The filler serves to improve the mechanical properties (e.g., strength) of the epoxy resin composition and lower the moisture absorption.

As the filler, any inorganic filler that is commonly used in the field of electronic materials may be used without particular limitation. In one example, inorganic fillers, such as silica, silica nitride, alumina, aluminum nitride, and boron nitride, may be used, and these may be used alone or in combination of two or more. In one example, the filler may include alumina and silica. For example, alumina and silica may be included in a weight ratio of 9:1. In this case, further improved curability of the epoxy resin composition can be secured.

The shape of the filler is not particularly limited, and both angular and spherical shapes can be used. Non-limiting examples of the filler that can be used in the present invention include natural silica, synthetic silica, fused silica, etc., and spherical silica particles may be used.

The filler may include two or more types of fillers having different particle sizes. In this case, formability and workability of the epoxy resin composition can be further improved. In one example, the filler may include a first filler having an average particle diameter (D50) of 3.5-20 µm, for example, 3.5-15 µm, and a second filler having an average particle diameter (D50) of 0.1-3 µm, for example, 0.1-1 µm.

On the basis of the total weight of the epoxy resin composition, the content of the filler may be 50-95% by weight, for example, 70-95% by weight. When the content of the filler is less than the range stated above, the moisture absorption amount of the cured product may increase, which may decrease the reliability of a semiconductor device, and when the content of the filler exceeds the range stated above, the flowability may be lowered, and thus, the formability may be deteriorated.

### Siloxane

The epoxy resin composition of the present invention includes siloxane. The siloxane is disiloxane of a symmetrical structure having an alicyclic epoxy group at both ends, and, by using the siloxane having this structure, an epoxy resin composition for encapsulating a semiconductor device having excellent dispersibility, flowability and thermal conductivity can be provided. While the epoxy group included in the siloxane structure participates in the curing reaction between epoxy and phenol, side effects, such as reduction in strength and generation of flow marks, which may occur when a conventional siloxane compound is added, are reduced. In particular, by including an alicyclic epoxy group, a phenomenon in which the glass transition temperature is lowered when siloxane having a linear structure is used, may be prevented. In addition, siloxane having a symmetrical structure has structural similarity with crystalline epoxy resin, and thus cross-linking with the epoxy resin is enabled, so that the dispersibility increases and the design of a higher filler content is enabled, and the EMC thermal conductivity can be improved.

The siloxane may be represented by Chemical Formula 1 below:

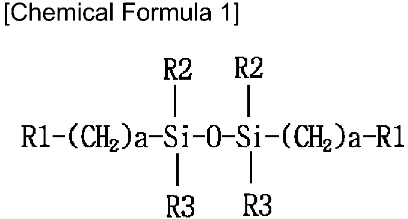

wherein:
R1 is an alicyclic epoxy group having 5-10 carbon atoms;
R2 is hydrogen or a substituted or unsubstituted hydrocarbon group having 1-5 carbon atoms;
R3 is hydrogen or a substituted or unsubstituted hydrocarbon group having 1-5 carbon atoms; and
a is an integer from 1 to 10.

In one example, in the above formula, R1 is an alicyclic epoxy group having 5-10 carbon atoms, R2 is hydrogen or a substituted or unsubstituted alkyl group having 1-5 carbon atoms, R3 is hydrogen or a substituted or unsubstituted alkyl group having 1-5 carbon atoms, and a is an integer from 1 to 10.

In one example, in the above formula, R1 is an alicyclic epoxy group having 5-7 carbon atoms, R2 is hydrogen or a substituted or unsubstituted alkyl group having 1-3 carbon atoms, R3 is hydrogen or a substituted or unsubstituted alkyl group having 1-3 carbon atoms, and a is an integer from 1 to 5.

In one example, in the above formula, R1 is an alicyclic epoxy group having 6 carbon atoms, R2 is a methyl group, R3 is a methyl group, and a is 2.

In one example, the siloxane is represented by Chemical Formula 2 below:

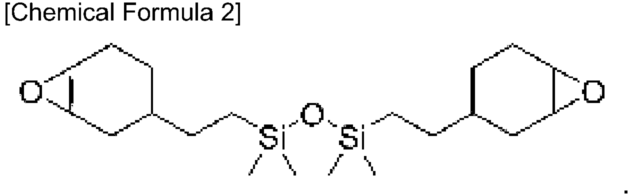

As the siloxane, one having a molecular weight of 200-800 g/mol, for example, 250-450 g/mol, and a viscosity (25 °C) of 5-1,000 mPa·s, for example, 10-200 mPa·s, may be used. When the molecular weight is less than the range stated above, the formability may be deteriorated, and when the molecular weight exceeds the range stated above, the flowability may be deteriorated. When the viscosity exceeds the range stated above, the flowability may be deteriorated.

On the basis of the total weight of the epoxy resin composition, the content of the siloxane may be 0.1-10% by weight, for example, 0.1-3% by weight. When the content of the siloxane is less than the range stated above, the dispersibility may be deteriorated, and when the content of the siloxane exceeds the range stated above, the formability and strength may be deteriorated.

### Additives

The epoxy resin composition of the present invention may additionally include additives that are commonly used in the composition. Non-limiting examples of usable additives include a catalyst, a coupling agent, a coloring agent, a release agent, and the like.

A catalyst promotes a curing reaction, and usable examples thereof may include an imidazole-based compound, a naphthalene-based latent catalyst, an amine-based compound, an organometallic compound, an organophosphorus compound, a boron compound, and the like. A coupling agent promotes the bonding between inorganic and organic materials, and amino silane, epoxy silane, etc. may be used. A coloring agent is added to impart a color to the resin composition, and carbon black, bengala, etc. may be used as the coloring agent. A release agent is added to ensure releasability between EMC and a mold, and paraffin wax, carnauba wax, polyethylene wax, ester wax, etc. may be used as the release agent.

The additives may be added within a content range known in the art, and, for example, on the basis of the total weight of the epoxy resin composition, may be included in an amount of 0.01-5% by weight, but is not limited thereto.

The epoxy resin composition according to the present invention can be prepared by a conventional method known in the art, for example, a melt-kneading method using a banbury mixer, a kneader, a roll, a single- or twin-screw extruder, and co-kneader.

The epoxy resin composition of the present invention can be manufactured in powder form, granular form, and the like. In particular, the epoxy resin composition according to the present invention has excellent swelling inhibition properties and can be manufactured in a granular form and applied to a compression molding method.

In one example, a powder-type or granular-type epoxy resin composition can be manufactured by uniformly mixing the above-described components, melting and mixing at a temperature of 80-130 °C by using a heat kneader, cooling to room temperature, and then pulverizing to a powder state, followed by sieving, but not limited thereto.

### <Semiconductor Device and Automotive Parts>

The present invention provides a molded semiconductor device using the above-described epoxy resin composition. The semiconductor device may be a transistor, a diode, a microprocessor, a semiconductor memory, or a power semiconductor.

In addition, the present invention provides an automotive part molded by using the above-described epoxy resin composition. In an example, the epoxy resin composition can be used as a molding material to fix and seal components in an automotive part, and, specifically, a permanent magnet may be inserted into an empty space formed in a rotor core of a vehicle motor, and the epoxy resin composition of the present invention may be filled between the empty space and the permanent magnet to fix the permanent magnet in the rotor core.

A method for molding a semiconductor device or molding an automotive part by using the epoxy resin composition of the present invention may be appropriately selected and performed according to a conventional method in the art, for example, transfer molding, compression molding, injection molding, and the like.

### [Modes of the Invention]

Hereinafter, the present invention will be described in more detail through examples. However, the following examples are only for a better understanding of the present invention, and the scope of the present invention is not limited to the examples in any sense.

### [Examples 1-2]

After blending various components according to the compositions shown in Table 1, the blended product was melted and mixed at a temperature of 100-130 °C by using a melt kneader, cooled to room temperature, and pulverized into powder, followed by sieving, thereby preparing the granular epoxy resin composition of each example.

### [Comparative Examples 1-6]

Except for the compositions shown in Table 1 below, granular epoxy resin compositions of each comparative example were prepared in the same manner as in Examples.

**[Table 1]**

| Component (wt%) | Example 1 | Example 2 | Comp. Ex. 1 | Comp. Ex. 2 | Comp. Ex. 3 | Comp. Ex. 4 | Comp. Ex. 5 | Comp. Ex. 6 |
|---|---|---|---|---|---|---|---|---|
| Epoxy resin | 3.3 | 2.6 | 3.7 | 3.3 | 3.3 | 3.3 | 3.3 | 3.3 |
| Curing agent 1 | 1.7 | 1.4 | 1.7 | 1.7 | 1.7 | 1.7 | 1.7 | 1.7 |
| Curing agent 2 | 1 | 0.8 | 1 | 1 | 1 | 1 | 1 | 1 |
| Filler | 92.5 | 93.5 | 92.5 | 92.5 | 92.5 | 92.5 | 92.5 | 92.5 |
| Siloxane 1 | 0.4 | 0.6 | | | | | | |
| Siloxane 2 | | | | 0.4 | | | | |
| Siloxane 3 | | | | | 0.4 | | | |
| Siloxane 4 | | | | | | 0.4 | | |
| Siloxane 5 | | | | | | | 0.4 | |
| Siloxane 6 | | | | | | | | 0.4 |
| Catalyst | 0.2 | 0.2 | 0.2 | 0.2 | 0.2 | 0.2 | 0.2 | 0.2 |
| Coupling agent | 0.5 | 0.5 | 0.5 | 0.5 | 0.5 | 0.5 | 0.5 | 0.5 |
| Coloring agent | 0.3 | 0.3 | 0.3 | 0.3 | 0.3 | 0.3 | 0.3 | 0.3 |
| Release agent | 0.1 | 0.1 | 0.1 | 0.1 | 0.1 | 0.1 | 0.1 | 0.1 |
| Total | 100 | 100 | 100 | 100 | 100 | 100 | 100 | 100 |

Epoxy resin: 4,4-bis(2,3-epoxypropoxy)-3,3,5,5-tetramethyl(1,1-biphenyl)
Curing agent 1: Phenol polymer with 4,4-bis(methoxymethyl)1,1-bisphenyl (Cas no. 0205830-20-2, viscosity (150 °C): 90 mPa·s, equivalent weight (EW): 210 g/eq)
Curing agent 2: Phenol polymer with 1,4-bis(methoxymethyl)benzene (Cas no. 0026834-02-6, Mw: 580 g/mol)
Filler: Aluminum oxide 90 wt% + Silicon dioxide 10 wt% (DENKA, DAB-10FC)
Siloxane 1: 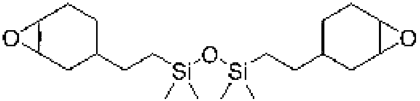 (bis-epoxycyclohexyl disiloxane)
Siloxane 2: Allyl phthalimide trisiloxane
Siloxane 3: 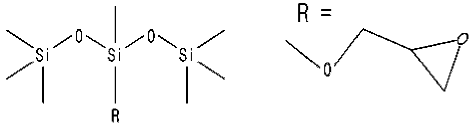
Siloxane 4: 3-[2-(3,4-epoxycyclohexyl)ethyl]-heptamethyltrisiloxane
Siloxane 5: 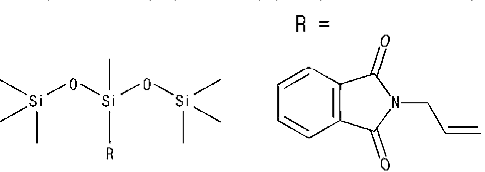
Siloxane 6: 1,3-Bis(3-(2,3-epoxypropoxy)propyl) 1,1,3,3-tetramethyldisiloxane
Catalyst: Triphenylphosphine
Coupling agent: Silane, trimethoxy[3-(oxiranylmethoxy)propyl]-
Coloring agent: Carbon Black
Release agent: Ethene homopolymer, oxidized

### [Evaluation of Properties]

The properties of the epoxy resin compositions prepared in Examples and Comparative Examples were measured as follows, and the results are shown in Table 2 below.

### Spiral flow

After molding the epoxy resin compositions prepared according to Examples and Comparative Examples by using a spiral flow mold in a heat transfer molding machine (pressure: 70 kg/cm²; temperature: 175 °C; curing time: 120 seconds), the flowability of each product was measured.

### Gel time

After putting the epoxy resin compositions prepared according to Examples and Comparative Examples in a gel timer and spreading them widely and evenly, the gel time of each product measured.

### Thermomechanical Analyzer (TMA)

The epoxy resin compositions prepared according to Examples and Comparative Examples were molded in a heat transfer molding machine (pressure 70 kg/cm², temperature 175 °C, curing time 120 seconds) and post-mold cured (PMC) (175 °C, 4 hours) to produce 6 × 6 × 6 mm³ size specimens. By using a thermomechanical analyzer (TMA), the glass transition temperature and coefficient of linear expansion of each specimen were measured while elevating the temperature from 25 °C to 300 °C at a temperature elevation rate of 10 °C/min.

### Universal Testing Machine (UTM)

The epoxy resin compositions prepared according to Examples and Comparative Examples were molded in a heat transfer molding machine (pressure 70 kg/cm², temperature 175 °C, curing time 120 seconds) and post-mold cured (PMC) (175 °C, 4 hours) to produce 125 × 12.5 × 6 mm³ size specimens. By using a universal testing machine (UTM), the flexural strength of each specimen was measured at a test speed of 2.6 mm/min under 3-point bending conditions.

### Thermal conductivity

The epoxy resin compositions prepared according to Examples and Comparative Examples were molded in a heat transfer molding machine (pressure 70 kg/cm², temperature 175 °C, curing time 120 seconds) and post-mold cured (PMC) (175 °C, 4 hours) to produce specimens having a size of 3 mm (diameter) × 2 mm (thickness). By using a thermal conductivity measuring instrument, the thermal conductivity of each specimen was measured by a modified transient plane source (MTPS) method.

### MGP mold

The epoxy resin compositions prepared according to Examples and Comparative Examples were molded in a MGP mold (pressure: 70 kg/cm²; temperature: 175 °C; curing time: 120 seconds) to produce specimens having a chip portion thickness of 200 µm, and the occurrence of flow marks on the surface of each specimen was observed with the naked eye. Non-occurrence of flow marks was evaluated as good, and occurrence of flow marks was evaluated as poor.

**[Table 2]**

| Property | | Unit | Example 1 | Example 2 | Comp. Ex. 1 | Comp. Ex. 2 | Comp. Ex. 3 | Comp. Ex. 4 | Comp. Ex. 5 | Comp. Ex. 6 |
|---|---|---|---|---|---|---|---|---|---|---|
| S/F (@175°C) | | inch | 55 | 45 | 42 | 50 | 35 | 52 | 52 | 48 |
| G/T (@175°C) | | sec | 42 | 40 | 40 | 42 | 38 | 42 | 42 | 42 |
| TMA | Tg (2nd cycle) | °C | 120 | 118 | 123 | 107 | 110 | 112 | 105 | 110 |
| | a1 (60-100°C) | ppm | 12 | 12 | 12 | 13 | 12 | 13 | 13 | 12 |
| | a2 (200-240 °C) | ppm | 30 | 30 | 31 | 34 | 30 | 31 | 36 | 30 |
| UTM | F/S (@RT) | kgf/mm² | 13.5 | 13.5 | 14 | 10.5 | 11 | 11.5 | 10 | 12.5 |
| Thermal conductivity | | W/m·K | 5 | 6 | 4.8 | 4.8 | 4.8 | 4.8 | 4.9 | 5 |
| MGP mold | Flow mark | | Good | Good | Good | Poor | Good | Good | Poor | Good |

As shown in Table 2, the epoxy resin compositions of Examples 1 and 2, comprising the siloxane (siloxane 1) according to the present invention, which is disiloxane of a symmetric structure having an alicyclic epoxy group at both ends, showed excellent properties in overall measurement items.

However, the epoxy resin composition of Comparative Example 1, not comprising siloxane; the epoxy resin compositions of Comparative Examples 2, 3, and 5, using siloxanes (siloxanes 2, 3, and 5) having no epoxy group at both ends; the epoxy resin composition of Comparative Example 4, comprising siloxane (siloxane 4) having an alicyclic epoxy group at a side chain, not at both ends; and the epoxy resin composition of Comparative Example 6, using siloxane (siloxane 6) having an epoxy group, instead of an alicyclic epoxy group, at both ends, showed poor properties, compared to the epoxy resin compositions of Examples 1 and 2, in all measurement items.

### [Industrial Applicability]

The present invention provides an epoxy resin composition for molding having excellent dispersibility, flowability and thermal conductivity, and a semiconductor device molded by using the same.

## Claims

1. An epoxy resin composition comprising an epoxy resin, a curing agent, a filler, and a siloxane, wherein the siloxane is a disiloxane of a symmetrical structure having an alicyclic epoxy group at both ends.

2. The epoxy resin composition as claimed in claim 1, wherein the epoxy resin has an epoxy equivalent weight (EEW) of 100-500 g/eq, and a softening point of 30-150 °C, and the curing agent has a hydroxy equivalent weight of 90-300 g/eq, and a softening point of 50-120 °C.

3. The epoxy resin composition as claimed in claim 1, wherein the siloxane is represented by Chemical Formula 1 below: 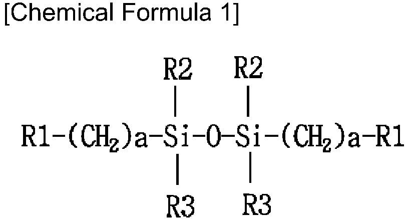 wherein:
R1 is an alicyclic epoxy group having 5-10 carbon atoms;
R2 is hydrogen or a substituted or unsubstituted hydrocarbon group having 1-5 carbon atoms;
R3 is hydrogen or a substituted or unsubstituted hydrocarbon group having 1-5 carbon atoms; and
a is an integer from 1 to 10.

4. The epoxy resin composition as claimed in claim 1, wherein the siloxane has a molecular weight of 200-800 g/mol and a viscosity (25 °C) of 5-1,000 mPa·s.

5. The epoxy resin composition as claimed in claim 1, wherein on the basis of the total weight of the epoxy resin composition, the epoxy resin composition comprises 1-20% by weight of the epoxy resin, 1-20% by weight of the curing agent, 50-95% by weight of the filler, and 0.1-10% by weight of the siloxane.

6. A semiconductor device molded by using the epoxy resin composition according to any one of claims 1 to 5.
